## Europäisches Patentamt

## European Patent Office

## Office européen des brevets

(19)

(11) Numéro de publication: **0 169 124**
**B1**

(12) # FASCICULE DE BREVET EUROPÉEN

(45) Date de publication du fascicule du brevet:
**13.01.88**

(51) Int. Cl.⁴: **H 03 F 3/60**

(21) Numéro de dépôt: **85401267.1**

(22) Date de dépôt: **25.06.85**

(54) Structure d'un étage d'amplificateur équilibré fonctionnant en hyperfréquences.

(30) Priorité: **10.07.84 FR 8410943**

(43) Date de publication de la demande:
**22.01.86 Bulletin 86/4**

(45) Mention de la délivrance du brevet:
**13.01.88 Bulletin 88/2**

(84) Etats contractants désignés:
**DE GB IT SE**

(56) Documents cité:
**EP-A-0 026 788**
**EP-A-0 066 015**

**1982 IEEE MTT-S INTERNATIONAL MICROWAVE SYMPOSIUM DIGEST, 15-17 juin 1982, Dallas, Texas, pages 225-227, M.H. BEASLEY, Jr., Piscataway, US; J. GOEL et al.: "A 1 watt GaAs power amplifier for the NASA 30/20 Ghz communication system"**
**1978 IEEE MTT-S INTERNATIONAL MICROWAVE SYMPOSIUM DIGEST, 27-29 juin 1978, Ottawa, pages 285-287, IEEE, Piscataway, US; W.C. TSAI: "A 5-watt C-band FET amplifier"**
**L'ONDE ELECTRIQUE, vol. 61, no. 11, novembre 1981, pages 17-23, Masson, Paris, FR; H.F. COOKE: "Les transistors à effet de champ micro-ondes"**

(73) Titulaire: **THOMSON- CSF, 173, Boulevard Haussmann, F-75379 Paris Cédex 08 (FR)**

(72) Inventeur: **Lefevre, Claudette, THOMSON- CSF SCPI 173, bld Haussmann, F-75379 Paris Cedex 08 (FR)**
Inventeur: **Geffroy, Dominique, THOMSON- CSF SCPI 173, bld Haussmann, F-75379 Paris Cedex 08 (FR)**
Inventeur: **Le Creff, Maurice, THOMSON- CSF SCPI 173, bld Haussmann, F-75379 Paris Cedex 08 (FR)**

(74) Mandataire: **Taboureau, James, THOMSON- CSF SCPI 19, avenue de Messine, F-75008 Paris (FR)**

## Description

La présente invention concerne la structure d'un étage d'un amplificateur équilibré, fonctionnant dans le domaine des hyperfréquerces, et comportant deux voies couplées par un coupleur 3dB en entrée et un coupleur 3dB en sortie de l'étage: un transistor à effet de champ est inséré dans chacune des deux voies. Selon l'invention, au lieu de monter une pastille de transistor à effet de champ de puissance sur chacune des deux voies de l'étage de l'amplificateur équilibré, on ne monte qu'une cellule d'un transistor à effet de champ sur chaque voie, c'est-à-dire, qu'une seule pastille de transistor à effet de champ est utilisée pour l'ensemble des deux voies, à condition que cette pastille comporte au moins deux régions de grille et deux régions de drain, ces régions n'étant pas réunies entre elles - prises deux à deux - à la surface de la pastille du transistor à effet de champ.

Les amplificateurs équilibrés sont bien connus en hyperfréquence: les deux transistors à effet de champ qui y sont utilisésun pour chaque voie - ont fréquemment une structure multiple, souvent interdigitée, c'est-à-dire qu'une pluralité de petits transistors élémentaires sont montés en parallèle. Il est nécessaire que ces transistors de signaux soient petits, ou plus exactement aient une petite longueur de grille, pour osciller à de très hautes fréquences. Pour des raisons technologiques - un transistor élémentaire peut être mal réalisé et ne pas fonctionner - et de rendement de fabrication, les transistors élémentaires sont groupés en cellules, dans lesquelles les métallisations de source, de grille et de drain sont mises en commun, et les cellules sont groupées en parallèle pour augmenter la puissance disponible à la sortie du transistor: le groupement des cellules se fait le plus souvent par des fils thermocomprimés qui réunissent les métallisations des cellules aux bornes correspondantes du circuit extérieur.

Jusqu'à présent, toutes les cellules d'un transistor à effet de champ étaient utilisées, et câblées par fils sur une même voie d'un étage amplificateur équilibré. Selon l'invention, une seule cellule d'une pastille de transistor à effet de champ est utilisée par voie d'un étage amplificateur équilibré. Les autres cellules sont utilisées soit pour l'autre voie, soit pour d'autres étages, car un amplificateur équilibré hyperfréquence comporte le plus souvent une pluralité d'étages pour obtenir le gain nécessaire.

Cette solution présente de nombreux avantages. C'est un fait expérimental qu'une cellule seule chargée par 50 ohms a un gain plat en fonction de la fréquence, tandis qu'un transistor chargé par 50 ohms comportant deux cellules ou plus en parallèle n'a pas une courbe de gain plat: de ce fait la compensation nécessaire est moindre avec une seule cellule qu'avec deux cellules ou plus, et comme cette compensation se fait au moyen de self et d'aptateurs d'impédance ou éventuellement de capacités, la compensation nécessaire est réduite en surface occupée sur le substrat. Ce qui n'empêche pas que le gain obtenu par un étage, après réglage, est le même mais la puissance disponible en sortie de l'amplificateur équilibré est diminué de trois dB environ. Cet inconvénient de l'invention est facilement contourné dans un amplificateur, soit en montant deux cellules en parallèle soit en changeant de type de transistor, pour l'étage de sortie seulement.

Par ailleurs cette solution permet de monter plus haut en fréquence, car l'utilisation d'une cellule au lieu de deux cellules montées en parallèle permet, avec des transistors à effet de champ commerciaux dont les limites sont par exemple 18GHz, de réaliser des amplificateurs à 26GHz en les utilisant conformément à l'invention. Enfin, le fait d'utiliser une seule cellule au lieu de deux dans chaque voie des étages équilibrés divise par deux le courant de polarisation drain source, pour un gain identique.

De façon plus précise l'invention concerne une structure d'un étage d'amplificateur équilibré fonctionnant en hyperfréquences et comportant entre ses bornes d'entrée et de sortie deux voies parallèles couplées par deux coupleurs dits "3dB", chaque voie comportant un semiconducteur à effet de champ d'amplification, cet étage étant caractérisé en ce que, pour chaque voie, le semiconducteur d'amplification est constitué par une seule cellule d'un transistor à effet de champ comportant lui-même au moins deux cellules, une cellule étant formée par une pluralité de transistors élémentaires à effet de champ dont les grilles sont réunies à une première métallisation et les drains réunis à une seconde métallisation, les première et seconde métallisations étant commune à une cellule mais isolées des métallisations des autres cellules.

L'invention sera mieux comprise par la description d'un exemple de réalisation, cette description s'appuyant sur les figures jointes en annexe qui représentent:

- figure 1: schéma électrique d'un étage d'amplificateur équilibré selon l'art connu,
- figure 2: vue en plan d'un transistor à effet de champ à deux cellules selon l'art connu,
- figure 3: plan de câblage d'un transistor à effet de champ dans une voie d'un étage d'amplificateur selon l'art connu,
- figure 4: plan de câblage de principe d'un transistor à effet de champ dans une voie d'un étage d'amplificateur selon l'invention,
- figure 5: schéma simplifié d'un étage d'amplificateur équilibré réalisé selon l'invention,
- figures 6 et 7: courbes comparées de gain en fonction de la fréquence pour une cellule d'un transistor à effet de champ et pour un transistor a effet de champ comportant deux cellules groupées en parallèle,
- figure 8: schéma simplifié du câblage d'une pastille de transistor à effet de champ de puissance en vue de réaliser deux étages d'un amplificateur, avec une seule pastille selon l'invention.

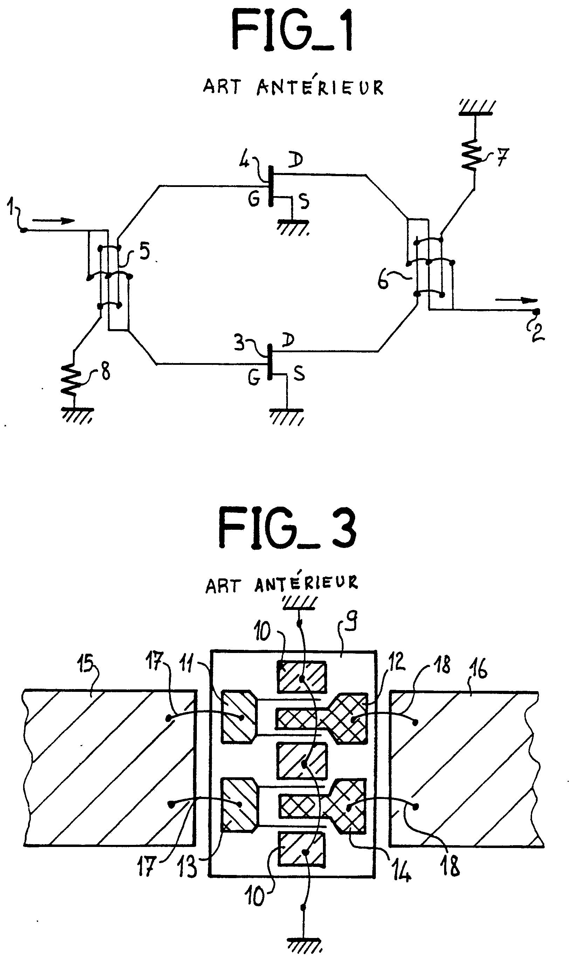

La figure 1 représente le schéma électrique d'un étage d'amplificateur équilibré selon l'art connu. Cet étage d'amplificateur est réalise au moyen de microbandes, qui pour simplifier la figure sont ici représentées sous forme de simples lignes, de même que les circuits de polarisation ne sont pas représentés.

Dans sa structure habituelle, un étage d'amplificateur comprend entre l'entrée 1 de l'étage et sa sortie 2 deux voies qui sont couplées au moyen de coupleurs appelés coupleurs 3dB. Sur une première voie, a partir de l'entrée 1, un transistor à effet de champ 3 est monté entre la ligne directe du coupleur 3dB 5 et la ligne couplée du coupleur 3dB 6, avec réflexion a travers une résistance de 50 ohms 7 qui est montée à la masse. La seconde voie de l'étage comporte le transistor à effet de champ 4, qui est réuni à la sortie 2 de l'étage par la voie directe du coupleur 3dB 6; cette seconde voie est couplée à la voie d'entrée par l'intermédiaire de la voie couplée du coupleur 3dB 5, avec réflexion de l'énergie dans une résistance 5 ohms 8 qui est montée à la masse.

Ce type d'étage d'amplificateur équilibré est fréquemment utilisé en hyperfréquence en raison de ses avantages: si l'impédance de charge en entrée 1 et en sortie 2 est égale à 50 ohms toute l'énergie due à des coefficients de réflexion égaux en amplitude et en phase dans chaque voie de l'étage équilibré est réfléchie dans les résistances 7 et 8 par les coupleurs, ce qui permet de désadapter symétriquement les deux transistors 3 et 4 en vue d'avoir un gain plat, souvent recherché dans un amplificateur hyperfréquence, mais cependant l'entrée et la sortie restent adaptées en fréquence.

Mais dans tous les cas connus, les transistors sont toujours montés avec leur source à la masse, et, jusqu'à présent, on a toujours utilisé des pastilles de transistor à effet de champ pour chacun des deux transistors 3 et 4, mais jamais une fraction de pastille seulement.

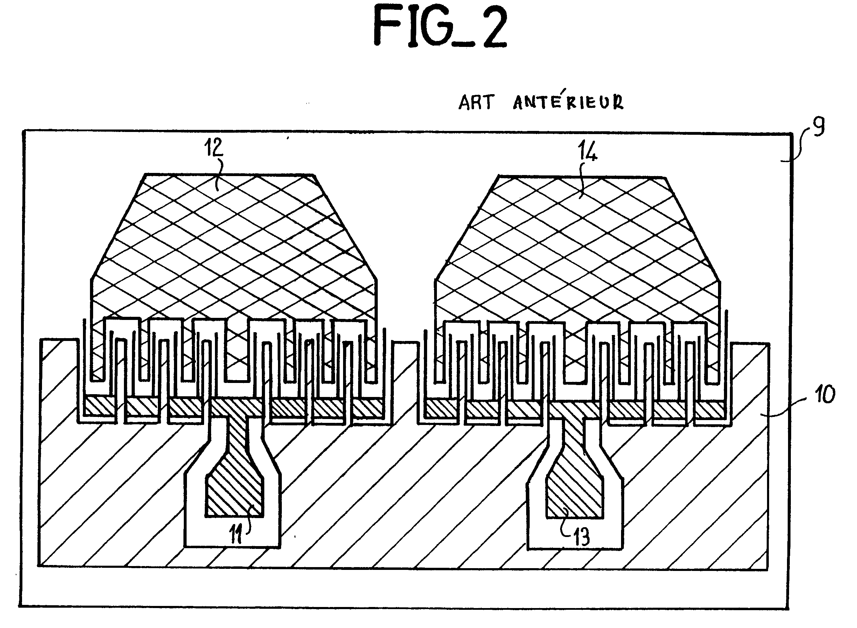

Cependant, l'usage d'une fraction de pastille est possible comme le montre la figure 2 qui représente la vue en plan d'un transistor à effet de champ selon l'art connu.

Etant donné que le domaine des fréquences considérées se trouve dans une gamme de 1 à 20GHzi les transistors à effet de champ qui peuvent travailler à de telles fréquences sont souvent des transistors obtenus par la collaboration d'un grand nombre de petits transistors élémentaires, car il est connu que pour un transistor à effet de champ, ce sont ses dimensions et en particulier la longueur de la grille, c'est-à-dire: la longueur de la distance qui sépare la source et le drain qui commande la fréquence de travail des transistors. Réaliser un transistor qui ait une très petite longueur de grille, donc qui travaille à très haute fréquence, mais une très grande largeur de cette grille pour délivrer la puissance nécessaire n'est qu'une oeuvre de l'esprit et ne correspond pas à la réalité. Pour cette raison, lorsqu'on a besoin d'une certaine puissance, par exemple de l'ordre de 1 à 2 watts jusqu'à des fréquences de 30 GHz tous les transistors à effet de champ utilisés sont réalisés sous forme de petits transistors élémentaires qui sont ensuite regroupés en cellules par des métallisations communes, ces cellules étant elles-mêmes regroupées pour donner un transistor de puissance.

La figure 2 représente les métallisations visibles à la surface de la pastille d'un transistor à effet de champ de moyenne puissance, connu. Si la pastille est représentée par un rectangle 9, un transistor à effet de champ comporte très fréquemment une métallisation de source 10, qui est unique pour l'ensemble du transistor. Sur la surface de cette pastille 9, les grilles de plusieurs petits transistors élémentaires sont regroupées et aboutissent sur un plot unique 11 tandis que les drains de ces mêmes transistors élémentaires sont regroupés et aboutissent sur un plot unique 12. Les transistors de signaux ainsi regroupés ayant en commun le plot de grille 11 et le plot de drain 12 constituent ce que l'on appelle une cellule dans un transistor. Sur la figure 2 est représentée une seconde cellule dans laquelle les transistors élémentaires ont en commun un plot de grille 13 et un plot de drain 14, mais d'autres configurations sont tout à fait possibles, et existent couramment, dans lesquelles un transistor à effet de champ regroupe quatre cellules et plus.

Le fait que dans une pastille de transistor à effet de champ la métallisation de source soit unique n'a pas d'importance puisque dans le cas d'un amplificateur équilibré toutes les sources sont mises à la masse. Par contre, l'invention met à profit le fait que les transistors élémentaires sont regroupés en cellules, 11 + 12 et 13 + 14, pour utiliser ces cellules indépendamment les unes des autres.

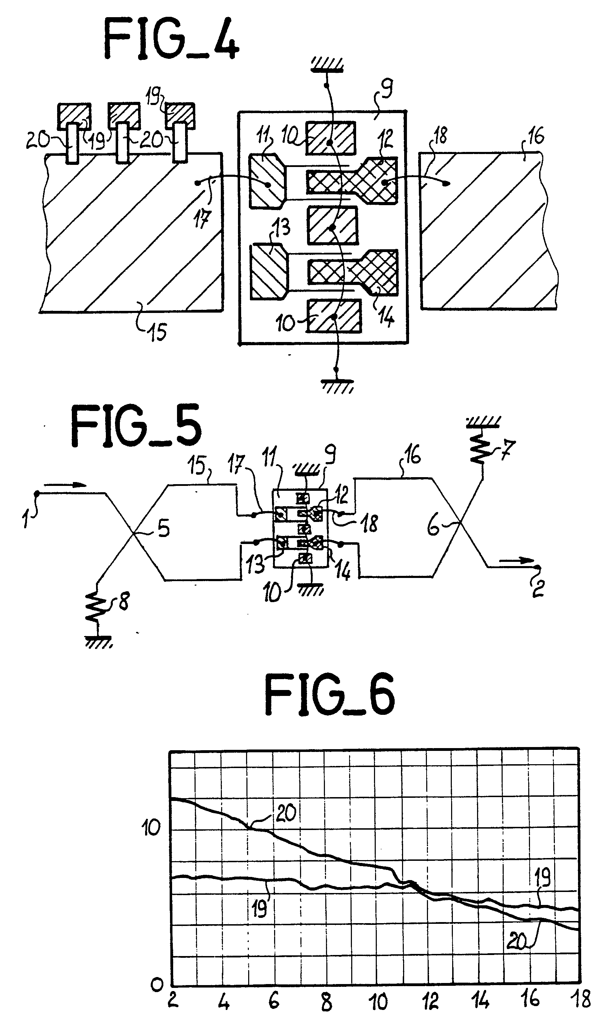

La figure 3 représenteune fraction d'une voie d'un amplificateur équilibré câblé selon l'art connu. Cette fraction concerne uniquement une pastille de transistor et les deux morceaux de microbandes sur lesquels sont montés la grille et le drain de ce transistor.

Le dessin de la pastille de transistor de la figure 2 est simplifié sur cette figure 3, de façon à faciliter la compréhension de la figure, et ce transistor est représenté possédant deux cellules, mais cette simplification n'a aucune portée sur les limites de l'invention quant au nombre de cellules. Si le transistor représenté en figure 3 est par exemple le transistor 3 de la ligne d'entrée de la figure 1, il est réuni par une microbande 15 à la ligne directe du coupleur d'entrée 3dB 5, et la sortie, c'est-à-dire le drain du transistor, est réuni par une microbande 16 à la ligne couplée du coupleur 3dB 6. Selon l'art connu, tel que représenté en figure 3, l'ensemble des cellules d'un transistor est utilisé et réuni aux lignes microbandes d'entrée et de sortie du transistor. Ainsi, les deux métallisations de grille 11 et 13 sont toutes deux réunies par des fils ou des rubans 17 à la ligne microbande d'entrée 15. Les deux métallisations de drain 12 et 14 sont également toutes deux réunies par des fils ou des rubans 18 à la ligne microbande de sortie 16. Selon l'invention, une seule cellule par pastille de transistor est utilisée par voies dans un étage d'un amplificateur équilibré. C'est ce que représente la figure 4.

La figure 4 reprend la même disposition qu'en figure 3 de façon à mieux montrer le fait qu'une cellule du transistor n'est pas utilisée. La cellule dont la métallisation de grille est 13 et la métallisation de drain est 14, n'est pas câblée par des fils aux deux lignes microbandes 15 et 16. Cette configuration a un peu un aspect de principe, car en fait on ne se contente pas d'utiliser seulement la fraction d'une pastille de transistor, et l'usage de la seconde cellule disponible sur la pastille du transistor sera montré ultérieurement.

Ainsi, par rapport à l'art connui dans l'invention on n'utilise plus un transistor complet mais une cellule regroupant plusieurs transistors élémentaires pour chaque voie d'un amplificateur équilibré. Cette solution est très avantageuse: en effet lorsqu'on utilise un transistor ne comportant qu'une seule cellule chargée par 50 ohms sur la grille et 50 ohms sur le drain, on a une courbe de gain en fonction de la fréquence qui est très proche du gain plat. Avec un transistor comportant deux cellules câblées ou plusi tel que représenté en figure 3, il faut ajouter sur la grille et le drain du transistor des cellules d'adaptation d'impédance. L'adaptation d'un transistor à une seule cellule câblée se fait avec une petite self et un petit adaptateur d'impédance sur l'entrée, et une petite self en sortie, parce que la courbe de gain en fonction de la fréquence est proche du gain plat. Par contre, avec un transistor comportant deux cellules câblées ou plus il faut un plus gros transformateur d'impédance à l'entrée, ainsi qu'un transformateur d'impédance en sortie. Si on considère la figure 4 les fils ou les rubans de liaison 17 et 18 qui réunissent entre eux, respectivement, le plot de grille 11 et la ligne microbande d'entrée 15 et le plot de drain 12 et la ligne microbande de sortie 16 constituent une petite self d'adaptation en entrée et en sortie. Etant donné que la cellule 11 + 12 de transistor élémentaire a un gain qui est presque plat, les adaptateurs d'impédance sont, pour ces fréquences, facilement réalisés sous forme de plots 19 qui sont déposés sur le substrat du circuit en même temps que les lignes microbandes 15. Le transistor étant monté sur son substrat et relié aux lignes microbandes 15 et 16, il est relativement facile, au cours de tests dynamiques, de connecter des petits rubans d'or 20 entre la ligne microbande d'entrée 15 et un ou plusieurs plots 19 jusqu'à ce que l'adaptation d'impédance soit obtenue: les adaptateurs d'impédance en entrée sont simplement les plots 19 et les rubans d'or 20.

Par contre, si l'on avait utilisé la totalité d'une pastille de transistor il aurait fallu ajouter sur le substrat qui porte le circuit deux transformateurs d'impédance, à plusieurs sections à l'entrée et à la sortie, qui sont, eux, réalisés sous forme de lignes microbandes c'est-à-dire qui occupent beaucoup plus de place.

La figure 5 représente le schéma simplifié d'un étage d'amplificateur équilibré selon l'invention. Cette figure est la transformée de la figure 1, avec deux transistors à effet de champ selon l'art connu, en une configuration selon l'invention dans laquelle une cellule de transistor à effet de champ intervient sur chaque voie de l'étage.

Cet étage d'amplificateur comporte une première voie, à partir de l'entrée 1 de l'étage, qui comprend le coupleur 3dB 5, une cellule 13 + 14 du transistor à effet de champ 9, et le coupleur 3dB 6 ainsi qu'une résistance 7 mise à la masse. La deuxième voie couplée de cet étage comporte, à partir de la résistance 8 mise à la masse, le coupleur 3dB 5, la cellule 11 + 12 du transistor 9, le coupleur 3dB 6 et la sortie 2. Comme en figure 1 les liaisons électriques sont en fait les lignes microbandes mais elles sont représentées sous forme de simples traits. On voit que la solution de l'invention consiste donc a utiliser les différentes cellules d'un transistor à effet de champ en les séparant, ou plus exactement en évitant de les réunir ensemble par des liaisons par fil ou par rubans, et en les faisant travailler en parallèle, sur les deux voies d'un étage d'amplificateur équilibré. Une autre solution qui sera exposée ultérieurement consiste à faire travailler ces cellules non pas en parallèle mais en cascade.

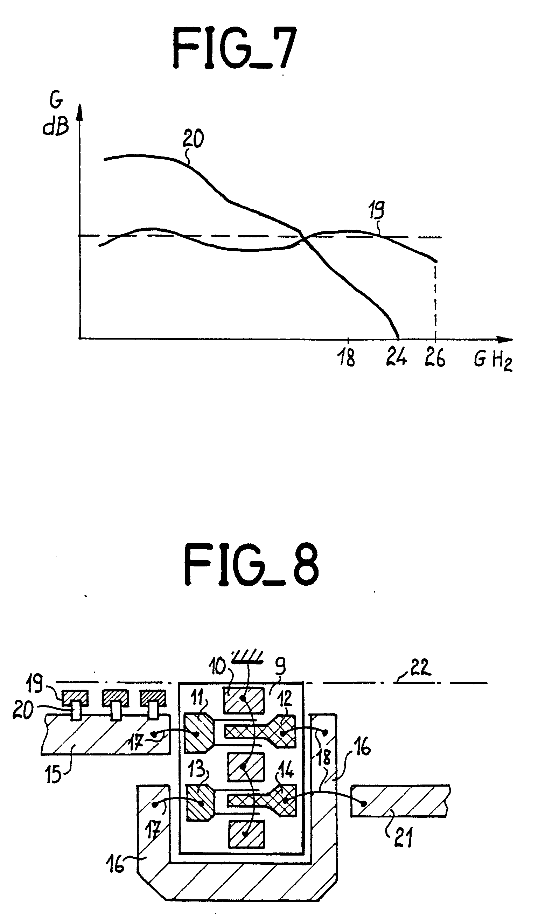

Les figures 6 et 7 reviennent sur ce qui a été exposé en ce qui concerne le gain d'une cellule par rapport au gain d'un transistor complet. En figure 6 la fréquence donnée en abscisse couvre la gamme de 2 à 18 GHz, tandis que le gain est donné en ordonnée, en décibels. Cette figure correspond à des relevés en laboratoire sur une même pastille de transistor chargé à l'entrée et à la sortie par une impédance de 50ohms. Lorsque l'on utilise une cellule seulement d'un transistor, on obtient une courbe de gain en fonction de la fréquence qui est représentée par la courbe 19 qui est remarquablement plate écart maximum 2db. Par contre, si on utilise une seconde cellule de ce même transistor, c'est-à-dire, que le transistor est monté selon la figure 3, on obtient alors une courbe de gain en fonction de la fréquence qui est représentée par la courbe 20 écart maximum 8db: cette courbe est loin du gain plat et nécessite une compensation, coûteuse en superficie à la surface d'un circuit hyperfréquence.

Le relevé de la figure 6 est limité entre 2 et 18 GHz, puisque le transistor étudié est donné pour 18 GHz de fréquence maximale. En fait, l'utilisation d'un transistor sous forme de cellule séparée, selon l'invention, permet de gagner en fréquence comme le montre la figure 7. La fréquence étant donnée en abscisse et le gain en ordonnée on voit que si l'on utilise deux cellules d'un même transistor chargé sur 50 ohms on obtient une courbe 20 qui correspond à un gain d'environ 4db pour 18 GHz et un gain nul pour 24GHz. Par contre, si l'on utilise une seule cellule, on obtient alors une courbe 19, relativement plate, le gain plat étant symbolisé par une ligne droite en pointillé, mais il est surtout intéressant de constater que dans ce cas la cellule travaille jusque 26 GHz au lieu de 18 GHz. Par conséquent, l'invention, en utilisant une partie de transistor à effet de champ au lieu d'utiliser la totalité d'un transistor pour chaque voie d'un étage d'amplificateur équilibré permet de repousser les limites de travail des amplificateurs équilibrés que l'on sait actuellement réaliser avec les transistors disponibles.

Enfin, la figure 8 représente le schéma de câblage d'une pastille de transistor à effet de champ, en vue de réaliser plusieurs étages d'un amplificateur, avec une seule pastille de transistor, selon l'invention.

Alors qu'en figure 5, deux cellules, 11+12 d'une part 13+14 d'autre part d'un même transistor travaillent en parallèle sur les deux voies parallèles d'un étage d'amplificateur équilibré, par contre en figure 8 ces deux mêmes cellules travaillent en cascade sur la même voie. La première voie d'un premier étage est constituée par la ligne microbande 15, réunie par un fil ou ruban 17 à une cellule 11+12, et une microbande de sortie 16, réunie à la cellule par un fil ou ruban 18. Cette même microbande 16 a une configuration qui lui permet de contourner la pastille de transistor de puissance et de constituer la microbande d'entrée du second étage de l'amplificateur, ce second étage étant formé par les grilles 13 et les drains 14, et réuni par des fils ou rubans 17 et 18 à la microbande d'entrée 16 et à la microbande de sortie 21.

Si la technologie le permet il est possible avec un transistor comportant plus de deux cellules, de réaliser plus de deux étages successifs d'un amplificateur équilibré. En outre, lorsque l'on dispose de transistor ayant au moins 4 cellules, il est alors possible de réaliser avec la même pastille de transistor deux étages successifs d'une même voie telle que représentée en figure 8, mais également les deux étages successifs de l'autre voie couplée, qui serait représentée selon le symétrique de la figure 8 par rapport à la ligne de symétrie 22. L'invention consiste donc à utiliser une pastille comme un circuit intégré dans lequel seraient réalisés plusieurs étages élémentaires d'amplification, ces étages n'étant plus utilisés tous en parallèle et reliés par des métallisations, mais utilisés independamment les uns des autres, leur seul contact électrique commun étant le contact de source 10, qui lui est à la masse.

C'est une approche d'utilisation monolithique des TEC comportant plusieurs cellules indépendantes.

De façon plus générale la structure selon l'invention reste valable pour tout transistor possédant un nombre pair de cellules indépendantes, ce qui permet de les faire travailler soit en parallèle soit en cascade. Cette solution apporte beaucoup d'avantages sur le nombre de transistors, ce qui permet donc d'augmenter la densité du circuit, la perte de puissance disponible à la sortie de l'avant dernier étage selon l'invention étant compensée dans le dernier étage de sortie.

**Revendications**

1. Structure d'un etage d'amplificateur équilibré, fonctionnant en hyperfréquences, et comportant entre ses bornes d'entrée (1) et de sortie (2) deux voies parallèles couplées par deux coupleurs (5, 6) dits "3dB", chaque voie comportant un semiconducteur à effet de champ (3, 4) d'amplification monté en source à la masse, cet étage étant caractérisé en ce que, pour chaque voie, le semiconducteur d'amplification (3 ou 4) est constitué par une seule cellule d'un transistor à effet de champ (9) comportant lui-même au moins deux cellules, une cellule étant formée par une pluralité de transistors élémentaires à effet de champ dont les grilles sont réunies à une première métallisation (11) et les drains réunis à une seconde métallisation (12), les première (11) et seconde (12) métallisations étant communes à une cellule mais isolées des métallisations correspondante des autres cellules.

2. Structure d'un étage d'amplificateur équilibré selon la revendication 1, caractérisé en ce que la métallisation de source (10) est commune à toutes les cellules du transistor à effet de champ.

3. Structure d'un étage d'amplificateur équilibré selon la revendication 2, caractérisé en ce que la métallisation de source (10) est mise à la masse.

4. Structure d'un étage d'amplificateur équilibré selon la revendication 1, caractérisée en ce que le transistor à effet de champ (9) comportant au moins deux cellules (11-12, 13-14), l'étage ne comprend qu'un seul transistor (9), une voie de l'étage étant connectée à une première cellule (11+12) et l'autre voie de l'étage connectée à une deuxième cellule (13-14).

5. Structure d'un étage d'amplificateur équilibré selon la revendication 1, caractérisée en ce que, le transistor à effet de champ (9) comportant un nombre pair de cellules (11+12, 13+14), chaque voie de l'étage est connectée à la métallisation de grille (11) d'une première cellule dont la métallisation de drain (12) est connectée à une ligne microbande (16) qui contourne la pastille du transistor (9) et ramène le signal électrique à l'entrée d'une seconde cellule (13+14), constituant une voie de l'étage suivant dans l'amplificateur équilibré, les deux cellules travaillant en cascade.

6. Structure d'amplicateur équilibré selon la revendication 1, caractérisée en ce que la courbe de gain en fonction de la fréquence et sa fréquence supérieure de fonctionnement sont meilleures que la courbe de gain et la fréquence supérieure du transistor de puissance à effet de champ (9) dans le cas où toutes les cellules sont utilisées en parallèle dans une même voie de l'étage.

**Patentansprüche**

1. Struktur einer Stufe eines Gegentaktverstärkers, der im Hyperfrequenzbereich arbeitet, mit zwei parallelen Strompfaden zwischen seinen Eingangsanschlüssen (1) und Ausgangsanschlüssen (2), die durch zwei sogenannte "3dB"-Koppler (5, 6) gekoppelt sind, wobei jeder Strompfad einen Feldeffekthalbleiter (3, 4) zur Verstärkung enthält, dessen Source mit der Masse verbunden ist, wobei die Stufe dadurch gekennzeichnet ist, daß für jeden Strompfad der Verstärkungshalbleiter (3 oder 4) durch eine einzige Zelle eines Feldeffekttransistors (9) gebildet ist, der seinerseits mindestens zwei Zellen enthält, wobei eine Zelle aus mehreren Elementarfeldeffekttransistoren gebildet ist, deren Gates mit einer ersten Metallisierung (11) verbunden sind und deren Drains mit einer zweiten Metallisierung (12) verbunden sind, wobei die erste (11) und zweite (12) Metallisierung einer Zelle gemeinsam, aber von den entsprechenden Metallisierungen der anderen Zellen getrennt ist.

2. Struktur einer Stufe eines Gegentaktverstärkers nach Anspruch 1, dadurch gekennzeichnet, daß die Sourcemetallisierung (10) allen Feldeffekttransistorzellen gemeinsam ist.

3. Struktur einer Stufe eines Gegentaktverstärkers nach Anspruch 2, dadurch gekennzeichnet, daß die Sourcemetallisierung (10) an Masse gelegt ist.

4. Struktur einer Stufe eines Gegentaktverstärkers nach Anspruch 1, dadurch gekennzeichnet, daß der Feldeffekttransistor (9) mindestens zwei Einheiten (11-12, 13-14) enthält und die Stufe nur einen einzigen Transistor (9) enthält, wobei ein Strompfad der Stufe mit einer ersten Einheit (11+12) und der andere Strompfad der Stufe mit einer zweiten Einheit (13-14) verbunden ist.

5. Struktur einer Stufe eines Gegentaktverstärkers nach Anspruch 1, dadurch gekennzeichnet, daß der Feldeffekttransistor (9) eine gerade Anzahl von Zellen (11+12, 13+14) enthält, und jeder Strompfad mit der Gatemetallisierung (11) einer ersten Zelle verbunden ist, deren Drainmetallisierung (12) an eine Mikrostreifenleitung (16) angeschlossen ist, die um das Transistorplättchen (9) herumführt und das elektrische Signal dem Eingang einer zweiten Zelle (13+14) zuführt, wobei sie einen Strompfad der folgenden Stufe im Gegentaktverstärker bildet und wobei die beiden Zellen in Kaskadenschaltung arbeiten.

6. Struktur eines Gegentaktverstärkers nach Anspruch 1, dadurch gekennzeichnet, daß die frequenzabhängige Verstärkung und seine Grenzfrequenz besser als die Verstärkungskurve und die Grenzfrequenz des Leistungsfeldeffekttransistors (9) sind, falls alle Zellen parallel in einem Strom-Pfad der Stufe verwendet werden.

**Claims**

1. Structure of a balanced amplifier stage operating in the hyperfrequency range, and comprising between its input (1) and output (2) terminals two parallel paths coupled by two 3dB couplers (5, 6), each path comprising an amplifying field effect transistor (3, 4) having its source connected to ground, this stage being characterized in that, for each path, the amplifying semiconductor (3 or 4) is formed by a single cell of a field effect transistor (9) which itself comprises at least two cells, one cell being formed by a plurality of elementary field effect transistors the gates of which are connected to a first metallization (11) and the drains being connected to a second metallization (12), the first (11) and second (12) metallizations being common to one cell but insulated from the corresponding metallization of the other cells.

2. Structure of a balanced amplifier stage according to claim 1, characterized in that the source metallization (10) is common to all the cells of the field effect transistor.

3. Structure of a balanced amplifier stage according to claim 2, characterized in that the source metallization (10) is connected to ground.

4. Structure of a balanced amplifier stage according to claim 1, characterized in that the field effect transistor (9) comprises at least two cells (11-12, 13-14), the stage comprising only a single transistor (9), one path of the stage being connected to a first cell (11+12) and the other path of the stage being connected to the second cell (13-14).

5. Structure of a balanced amplifier stage according to claim 1, characterized in that, the field effect transistor (9) comprising an even number of cells (11+12, 13+14), each path of the stage is connected to the gate metallization (11) of a first cell the drain metallization (12) of which is connected to a microstrip line (16) passing around the transistor chip (9) and transmitting the electric signal to the input of a second cell (13+14) forming a path of the following stage in the balanced amplifier, the two cells being operated in cascade.

6. Structure of a balanced amplifier according to claim 1, characterized in that the frequency dependent gain curve and its upper operating frequency are better than the gain curve and the upper frequency of the field effect power transistor (9) in case all the cells are used in parallel in the same path of the stage.

7

# FIG_1

ART ANTÉRIEUR

# FIG_3

ART ANTÉRIEUR

FIG_2

ART ANTÉRIEUR

# FIG_4

# FIG_5

# FIG_6

# FIG_7

# FIG_8